# FASCICULE DE BREVET EUROPEEN

(11) **EP 3 656 194 B1**
(45) Date de publication et mention de la délivrance du brevet: **25.08.2021**
(21) Numéro de dépôt: 18752580.3
(22) Date de dépôt: 10.07.2018
(51) Int. Cl.: H05K 7/20

(54) **ARCHITECTURE DE VENTILATION D'HÉLICOPTÈRE À CHAMBRE DE MÉLANGE**
VENTILATIONSARCHITEKTUR FÜR HUBSCHRAUBER MIT MISCHKAMMER
HELICOPTER VENTILATION ARCHITECTURE WITH MIXING CHAMBER

(30) Priorité: 20.07.2017 FR 1756899
(43) Date de publication de la demande: 27.05.2020
(73) Titulaire: Safran Electrical & Power, 31702 Blagnac Cedex (FR)
(72) Inventeur: CASTELLI, Christophe, CS 80049 31702 Blagnac Cedex (FR); DEL RIO, Fabien, CS 80049 31702 Blagnac Cedex (FR); CHALLAS, Florent, CS 80049 31702 Blagnac Cedex (FR); MANEL- DE - LALEUX, Jean, CS 80049 31702 Blagnac Cedex (FR)
(74) Mandataire: Gevers & Orès
(86) Numéro de dépôt international: PCT/FR2018/051735
(87) Numéro de publication internationale: WO 2019/016444

(56) Documents cités:
- EP-A2- 2 574 552
- US-A1- 2016 325 841

## Description

### 1. Domaine technique de l'invention

L'invention concerne une architecture de ventilation d'un hélicoptère. En particulier, l'invention concerne une architecture de ventilation de baies avioniques d'hélicoptère.

### 2. Arrière-plan technologique

L'état de la technique comprend notamment les demandes de brevet EP-A2-2 574 552 et US-A1-2016/325841.

Les hélicoptères comprennent au moins une baie avionique comprenant des équipements électroniques et/ou électriques. Ces équipements électroniques nécessitent une ventilation pour limiter l'augmentation de leur température, due à leur fonctionnement propre et/ou en raison des contraintes environnementales dans lesquelles évolue l'hélicoptère. Cette ventilation s'effectue en prélevant de l'air extérieur pour refroidir les équipements électroniques. Ce prélèvement et la circulation de l'air se fait grâce à la présence d'un ou plusieurs ventilateurs dans une architecture de ventilation permettant de ventiler la baie.

Sur des configurations récentes d'hélicoptères, l'hélicoptère peut comprendre deux baies avioniques, auquel cas la ventilation doit être doublée pour permettre de ventiler chaque baie avionique. Pour des raisons de redondance, chaque ventilation comprend au moins deux ventilateurs pour pallier la défaillance d'un des deux ventilateurs.

Dans le cadre d'exigences aéronautiques de plus en plus strictes pour des raisons de sécurité aérienne, la présence d'un seul ventilateur en fonctionnement par baie est possible pendant le vol en cas de panne du deuxième ventilateur, mais un hélicoptère ayant un seul ventilateur en fonctionnement par baie ne sera pas autoriser à redécoller sans changement du ventilateur défaillant.

Pour éviter ce problème, les hélicoptères sont fréquemment équipés de trois ventilateurs par baies, soit six ventilateurs. Pour permettre une meilleure sécurité en cas de problèmes d'alimentation électrique, ces groupes de ventilateurs sont composés de deux types de ventilateurs alimentés par des réseaux d'alimentation différents. Par exemple des ventilateurs alimentés en tension alternative (typiquement 115V) et des ventilateurs alimentés en tension continue (typiquement 28V).

Ainsi, l'augmentation du nombre et du type de ces ventilateurs pour des raisons de sécurité entraine une augmentation de la masse, du prix, et de la consommation électrique de l'architecture de ventilation. De plus, le rendement de chaque ventilateur est fréquemment diminué.

Les inventeurs ont donc cherché une solution à ces inconvénients.

### 3. Objectifs de l'invention

L'invention vise à pallier au moins certains des inconvénients des architectures de ventilation d'hélicoptère connues.

En particulier, l'invention vise à fournir, dans au moins un mode de réalisation de l'invention, une architecture de ventilation d'hélicoptère réduisant le nombre de ventilateurs nécessaires.

L'invention vise aussi à fournir, dans au moins un mode de réalisation, une architecture de ventilation d'hélicoptère de masse réduite.

L'invention vise aussi à fournir, dans au moins un mode de réalisation, une architecture de ventilation d'hélicoptère de coût inférieur aux solutions existantes.

L'invention vise aussi à fournir, dans au moins un mode de réalisation, une architecture de ventilation d'hélicoptère ayant une consommation électrique réduite.

L'invention vise aussi à fournir, dans au moins un mode de réalisation, une architecture de ventilation d'hélicoptère ayant un volume nécessaire pour son implantation réduit.

L'invention vise aussi à fournir, dans au moins un mode de réalisation de l'invention, une architecture de ventilation d'hélicoptère présentant une maintenance aisée.

L'invention vise aussi à fournir, dans au moins un mode de réalisation, une architecture de ventilation d'hélicoptère conforme aux exigences aéronautiques requises.

L'invention vise aussi à fournir, dans au moins un mode de réalisation, une architecture de ventilation d'hélicoptère réduisant le nombre de pannes rencontrées et améliorant la fiabilité.

L'invention vise aussi à fournir, dans au moins un mode de réalisation, une architecture de ventilation d'hélicoptère améliorant la disponibilité de l'hélicoptère.

L'invention vise aussi à fournir, dans au moins un mode de réalisation, une architecture de ventilation d'hélicoptère pouvant intégrer des fonctions supplémentaires.

### 4. Exposé de l'invention

Pour ce faire, l'invention concerne une architecture de ventilation d'hélicoptère, ledit hélicoptère comprenant au moins deux baies avioniques comprenant des équipements électroniques à ventiler, ladite architecture comprenant, pour chaque baie avionique :
- une entrée d'air, permettant à l'air extérieur de rentrer dans la baie avionique pour ventiler ladite baie avionique,
- une sortie d'air, permettant à l'air ventilant la baie avionique de quitter la baie avionique,
caractérisée en ce que l'architecture de ventilation comprend en outre :
- une chambre de mélange, reliée aux sorties d'air, configurée pour recevoir l'air provenant de toutes les baies avioniques,
- au moins un conduit d'air, connecté d'une part à la chambre de mélange, et d'autre part à une sortie d'évacuation de l'air vers l'extérieur,
- au moins deux ventilateurs, disposés et répartis dans le ou les conduits d'air.

Une architecture selon l'invention permet donc, grâce à la chambre de mélange, de mutualiser la ventilation des deux baies avioniques et de réduire ainsi par deux le nombre de ventilateurs embarqués. Le nombre réduit de ventilateurs permet ainsi une diminution du poids, du prix, du volume nécessaire et de la consommation électrique de l'architecture de ventilation.

La chambre de mélange (aussi appelée hub de refroidissement) permet de créer un volume tampon permettant la répartition optimale du flux d'air entre les baies avioniques quel que soit le nombre de ventilateurs mis en route. Ainsi, même si l'un des ventilateurs est en panne, les deux baies avioniques seront ventilées de la même façon évitant ainsi de devoir régler les pertes de charge au niveau de chaque baie. La chambre de mélange se compose d'un volume auquel est connecté les différents conduits dans lesquels circule l'air. Dans sa forme la plus simple, la chambre de mélange peut être formée d'un tube auquel sont connectés des conduits.

L'architecture reste conforme aux exigences aéronautiques puisque si un ventilateur tombe en panne, les baies avioniques restent correctement ventilées. De plus, la présence d'au moins deux ventilateurs mutualisés aux baies permet de conserver toujours un ventilateur en marche si l'un tombe en panne, ce qui permet le redécollage de l'hélicoptère. La disponibilité de l'hélicoptère est ainsi augmentée.

En outre, la diminution du nombre de ventilateurs diminue d'autant le nombre de panne possibles et la fiabilité de l'architecture est augmentée.

De préférence, l'hélicoptère comprend deux baies avioniques et l'architecture de ventilation comprend trois ou quatre ventilateurs.

Dans cette configuration, en tenant compte du retrait de ventilateurs par rapport aux architectures de l'art antérieur et de l'ajout d'une chambre de mélange et des conduits associés :
- la réduction de la masse de l'architecture est estimée à 35%,
- la réduction de la consommation électrique est estimée à 25%,
- la réduction du coût est estimée à 45%.

Avantageusement et selon une première variante de l'invention, l'architecture de ventilation comprend deux conduits d'air, chaque conduit d'air comprenant au moins un ventilateur.

Avantageusement et selon une deuxième variante de l'invention, l'architecture de ventilation comprend un unique conduit d'air, ledit unique conduit d'air comprenant lesdits au moins deux ventilateurs.

Selon cette variante de l'invention, la présence de l'ensemble des ventilateurs dans le même conduit d'air permet de faciliter la maintenance de l'architecture de ventilation, par exemple en cas de changement d'un ventilateur, car les ventilateurs sont tous regroupés au même endroit. En outre, les harnais et support des ventilateurs sont aussi mutualisés ce qui réduit leur complexité.

Avantageusement et selon l'invention, l'architecture de ventilation comprend, parmi les ventilateurs, au moins un ventilateur alimenté en tension alternative et au moins un ventilateur alimenté en tension continue.

Selon cet aspect de l'invention, les ventilateurs alimentés par des réseaux électriques ségrégés permettent une redondance supplémentaire.

Dans la première variante de l'invention décrite précédemment, chaque conduit d'air peut par exemple comprendre un ventilateur de chaque type.

Dans la seconde variante de l'invention décrite précédemment, les ventilateurs sont de toute façon tous disposés dans le même conduit d'air.

Selon d'autres variantes de l'invention, l'architecture de ventilation comprend uniquement des ventilateurs alimentés en tension alternative, éventuellement avec des tensions alternatives différentes selon les ventilateurs, ou uniquement des ventilateurs alimentés en tension continue, éventuellement avec des tensions continues différentes selon les ventilateurs. En général, les ventilateurs peuvent donc être alimentés tous par un même réseau électrique ou par des réseaux différents en terme de type de réseau et/ou de valeur de tension.

Avantageusement et selon l'invention, l'architecture de ventilation comprend en outre un conduit d'évacuation de fumée de l'hélicoptère, relié à la chambre de mélange.

Selon cet aspect de l'invention, la chambre de mélange permet l'adjonction de fonctionnalités supplémentaires, ici l'évacuation de la fumée, dont la ventilation est permise par les ventilateurs mutualisés.

L'invention concerne également un hélicoptère, comprenant au moins deux baies avioniques comprenant des équipements électroniques caractérisé en ce qu'il comprend une architecture de ventilation desdites baies avioniques selon l'invention.

L'invention concerne également une architecture de ventilation ou un hélicoptère caractérisés en combinaison par tout ou partie des caractéristiques mentionnées ci-dessus ou ci-après.

### 5. Liste des figures

D'autres buts, caractéristiques et avantages de l'invention apparaîtront à la lecture de la description suivante donnée à titre uniquement non limitatif et qui se réfère aux figures annexées dans lesquelles :
- la figure 1 est une vue schématique en coupe d'un hélicoptère comprenant une architecture de ventilation selon l'art antérieur,
- la figure 2 est une vue schématique en coupe d'un hélicoptère comprenant une architecture de ventilation selon un premier mode de réalisation de l'invention,
- la figure 3 est une vue schématique en coupe d'un hélicoptère comprenant une architecture de ventilation selon un deuxième mode de réalisation de l'invention.

### 6. Description détaillée d'un mode de réalisation de l'invention

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations. Sur les figures, les échelles et les proportions ne sont pas strictement respectées et ce, à des fins d'illustration et de clarté.

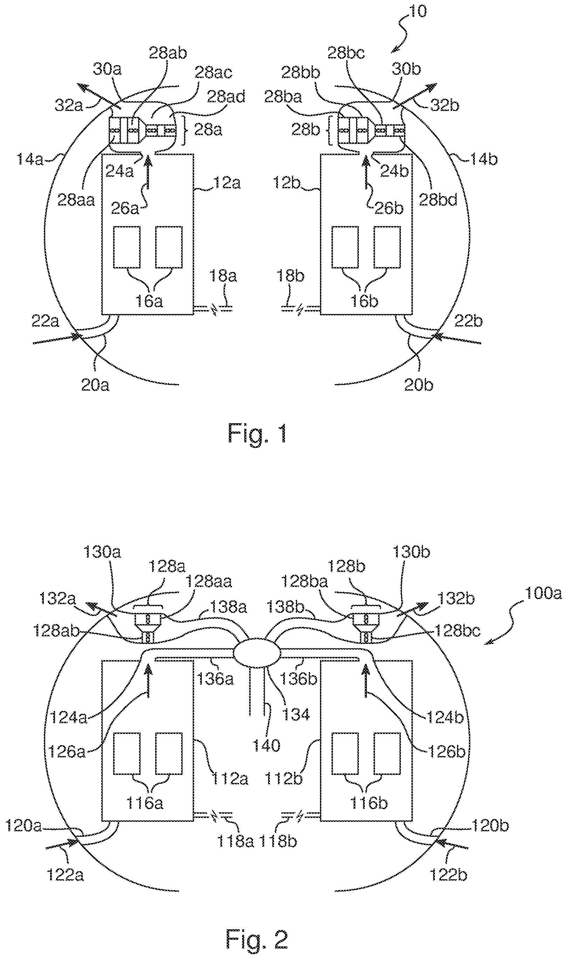

La figure 1 représente schématiquement en coupe un hélicoptère 10 comprenant deux baies avioniques une première baie 12a avionique et une deuxième baie 12b avionique, ventilées par une architecture de ventilation selon l'art antérieur. L'hélicoptère est symbolisés par des morceaux de fuselage 14a et 14b.

Les baies 12a, 12b avioniques comprennent des équipements 16a, 16b électroniques et/ou électriques à ventiler, alimentés chacun par une alimentation 18a, 18b.

Pour ventiler les baies avioniques, l'architecture de ventilation comprend pour chaque baie 12a, 12b avionique une entrée d'air 20a, 20b permettant l'entrée de l'air extérieur dans la baie, représentée par une flèche 22a, 22b.

L'air extérieur entre dans la baie et ventile les équipements 16a, 16b électroniques, et ressort de chaque baie 12a, 12b au niveau d'une sortie 24a, 24b d'air comme représenté par la flèche.

La circulation de l'air se fait grâce à quatre ventilateurs indépendants par baie :
- un premier ensemble 28a comprenant quatre ventilateurs, dont deux ventilateurs 28aa et 28ab alimentés en tension alternative, typiquement 115V, et deux ventilateurs 28ac et 28ad alimentés en tension continue, typiquement 28V ;
- un deuxième ensemble 28b comprenant quatre ventilateurs, dont deux ventilateurs 28ba et 28bb alimentés en tension alternative, typiquement 115V, et deux ventilateurs 28bc et 28bd alimentés en tension continue, typiquement 28V.

L'air traversé par ces ventilateurs est évacué vers l'extérieur respectivement par une première sortie 30a d'évacuation d'air pour l'air ventilant la première baie 12a avionique et une deuxième sortie 30b d'évacuation d'air pour l'air ventilant la deuxième baie 12b avionique, comme représenté par les flèches 32a et 32b.

L'architecture de ventilation selon l'invention vise à réduire ce nombre de ventilateur. Pour ce faire, la figure 2 représente schématiquement en coupe un hélicoptère 100a comprenant une première baie 112a avionique et une deuxième baie 112b avionique comprenant chacun des équipements 116a, 116b électroniques et/ou électriques alimentés par une alimentation 118a, 118b par baie, et équipé d'une architecture de ventilation selon un premier mode de réalisation de l'invention,

Comme dans l'art antérieur, l'architecture de ventilation comprend pour chaque baie un entrée 120a, 120b d'air et une sortie 124a, 124b d'air, l'air ventilant la première baie 112a avionique selon le chemin représenté par les flèches 122a et 126a, et l'air ventilant la deuxième baie 112b avionique selon le chemin représenté par les flèches 122b et 126b.

Selon l'invention, l'architecture de ventilation comprend une chambre 134 de mélange reliée aux sorties 124a et 124b d'air et recevant ainsi l'air provenant des deux baies 112a, 112b avioniques. La chambre 134 de mélange mutualise ainsi l'air provenant des deux baies 112a, 112b avionique. Un premier conduit 136a relie la sortie 124a d'air de la première baie 112a avionique à la chambre 134 de mélange, et un deuxième conduit 136b relie la sortie 124b d'air de la deuxième baie 112b avionique à la chambre 134 de mélange.

L'air entré dans la chambre 134 de mélange est rejeté vers l'extérieur au niveau d'au moins une sortie d'évacuation grâce à au moins un conduit d'air. Ici deux conduits 138a, 138b d'air relient la chambre 134 de mélange à deux sorties 130a, 130b d'évacuation d'air, permettant à l'air de retourner vers l'extérieur comme représenté par les flèches 132a et 132b.

La ventilation de l'air des baies 112a, 112b avionique est assurée par au moins deux ventilateurs, ici quatre ventilateurs, divisés en deux ensembles de ventilateurs :
- un premier ensemble 128a comprenant deux ventilateurs, un ventilateur 128aa alimenté en tension alternative (typiquement 115V), et un ventilateur 128ab alimenté en tension continue (typiquement 28V) ;
- un deuxième ensemble 128b comprenant deux ventilateurs, un ventilateur 128ba alimenté en tension alternative (typiquement 115V), et un ventilateur 128bb alimenté en tension continue (typiquement 28V).

L'aspiration est ainsi mutualisé, les deux ensembles de ventilateur permettant chacun la ventilation des deux baies 112a, 112b avioniques grâce à la chambre 134 de mélange.

Dans ce mode de réalisation, la chambre 134 de mélange est aussi connectée à un conduit supplémentaire permettant une autre fonction d'aspiration ou de ventilation, par exemple ici un conduit 140 d'évacuation de fumée en cas d'incendie dans l'hélicoptère.

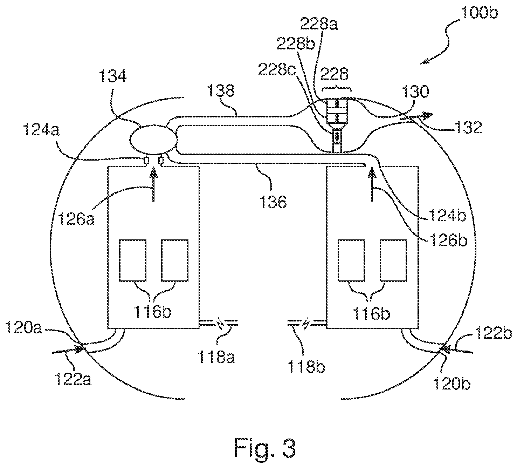

La figure 3 représente schématiquement en coupe un hélicoptère comprenant une architecture de ventilation selon un deuxième mode de réalisation de l'invention,

Ce deuxième mode de réalisation est similaire au premier mode de réalisation décrit en référence à la figure 2, hormis le fait que l'architecture de ventilation comprend une chambre 134 de mélange disposée au plus près de la première baie 112a avionique et reliée directement à la sortie 124a d'air de celle-ci, et que l'architecture de ventilation comprend un unique conduit 138 d'air.

Ainsi, les ventilateurs 228 de l'architecture de ventilation sont regroupés dans l'unique conduit 138 d'air. En particulier, l'architecture de ventilation comprend au moins deux ventilateurs, ici trois ventilateurs 228, dont deux ventilateurs 228a et 228b alimentés en tension alternative (typiquement 115V) et un ventilateur 228c alimenté en tension continue (typiquement 28V).

Les ventilateurs 228 sont ainsi regroupés au même endroit ce qui facilite leur maintenance.

Un conduit d'évacuation de fumée peut aussi être ajouté à ce mode de réalisation, connecté à la chambre de mélange, ainsi que tout autre conduit supplémentaire pouvant effectuer des fonctions supplémentaires d'aspiration ou de ventilation grâce aux ventilateurs et à la chambre de mélange.

## Revendications

1. Architecture de ventilation d'hélicoptère, ledit hélicoptère comprenant au moins deux baies (112a, 112b) avioniques comprenant des équipements (116a, 116b) électroniques à ventiler, ladite architecture comprenant, pour chaque baie avionique :
- une entrée (120a, 120b) d'air, permettant à l'air extérieur de rentrer dans la baie avionique pour ventiler ladite baie avionique,
- une sortie (124a, 124b) d'air, permettant à l'air ventilant la baie avionique de quitter la baie avionique,
l'architecture de ventilation comprenant en outre :
- une chambre (134) de mélange, reliée aux sorties d'air, configurée pour recevoir l'air provenant de toutes les baies avioniques,
- au moins un conduit (138, 138a, 138b) d'air, connecté d'une part à la chambre de mélange, et d'autre part à une sortie (130, 130a, 130b) d'évacuation de l'air vers l'extérieur,
- au moins deux ventilateurs (128a, 128b, 228), disposés et répartis dans le ou les conduits d'air.

2. Architecture de ventilation d'hélicoptère selon la revendication 1, **caractérisée en ce qu'**elle comprend deux conduits (138a, 138b) d'air, chaque conduit d'air comprenant au moins un ventilateur (128a, 128b).

3. Architecture de ventilation d'hélicoptère selon la revendication 1, **caractérisée en ce qu'**elle comprend un unique conduit (138) d'air, ledit unique conduit d'air comprenant lesdits au moins deux ventilateurs (228).

4. Architecture de ventilation d'hélicoptère selon l'une des revendications 1 à 3, **caractérisée en ce qu'**elle comprend, parmi les ventilateurs, au moins un ventilateur alimenté en tension alternative et au moins un ventilateur alimenté en tension continue.

5. Architecture de ventilation d'hélicoptère selon l'une des revendications 1 à 4, **caractérisé en ce qu'**elle comprend en outre un conduit (140) d'évacuation de fumée de l'hélicoptère, relié à la chambre de mélange.

6. Hélicoptère, comprenant au moins deux baies avioniques comprenant des équipements électroniques **caractérisé en ce qu'**il comprend une architecture de ventilation desdites baies avioniques selon l'une des revendications précédentes.

## Patentansprüche

1. Ventilationsarchitektur für Hubschrauber, wobei der Hubschrauber mindestens zwei Avionikbuchten (112a, 112b) umfasst, die zu ventilierende elektronische Ausstattungen (116a, 116b) umfassen, wobei die Architektur für jeden Avionikbucht umfasst:
- einen Lufteingang (120a, 120b), der der Außenluft ermöglicht, in den Avionikbucht einzutreten, um den Avionikbucht zu ventilieren,
- einen Luftausgang (124a, 124b), der der Luft, die den Avionikbucht ventiliert, ermöglicht, den Avionikbucht zu verlassen,
wobei die Ventilationsarchitektur weiter umfasst:
- eine Mischkammer (134), die mit den Luftausgängen verbunden ist und die konfiguriert ist, die aus allen Avionikbuchten stammende Luft zu empfangen,
- mindestens eine Luftleitung (138, 138a, 138b), die einerseits mit der Mischkammer und andererseits mit einem Ausgang (130, 130a, 130b) zur Abführung der Luft nach außen verbunden ist,
- mindestens zwei Ventilatoren (128a, 128b, 228), die in der oder den Luftleitungen angeordnet und verteilt sind.

2. Ventilationsarchitektur für Hubschrauber nach Anspruch 1, **dadurch gekennzeichnet, dass** sie zwei Luftleitungen (138a, 138b) umfasst, wobei jede Luftleitung mindestens einen Ventilator (128a, 128b) umfasst.

3. Ventilationsarchitektur für Hubschrauber nach Anspruch 1, **dadurch gekennzeichnet, dass** sie eine einzige Luftleitung (138) umfasst, wobei die einzige Luftleitung die mindestens zwei Ventilatoren (228) umfasst.

4. Ventilationsarchitektur für Hubschrauber nach einem der Ansprüche 1 bis 3, **dadurch gekennzeichnet, dass** sie unter den Ventilatoren mindestens einen Ventilator umfasst, der mit Wechselspannung versorgt wird, und mindestens einen Ventilator, der mit Gleichspannung versorgt wird.

5. Ventilationsarchitektur für Hubschrauber nach einem der Ansprüche 1 bis 4, **dadurch gekennzeichnet, dass** sie weiter eine Leitung (140) zur Abführung von Rauch des Hubschraubers umfasst, die mit der Mischkammer verbunden ist.

6. Hubschrauber, umfassend mindestens zwei Avionikbuchten, die elektronische Ausstattungen umfassen, **dadurch gekennzeichnet, dass** er eine Ventilationsarchitektur der Avionikbuchten nach einem der vorstehenden Ansprüche umfasst.

## Claims

1. Helicopter ventilation architecture, said helicopter comprising at least two avionics bays (112a, 112b) comprising electronic equipment (116a, 116b) to be ventilated, said architecture comprising, for each avionics bay:
- an air inlet (120a, 120b), allowing outside air to enter the avionics bay to ventilate said avionics bay,
- an air outlet (124a, 124b), allowing air ventilating the avionics bay to exit the avionics bay,
the ventilation architecture further comprising:
- a mixing chamber (134), connected to the air outlets, configured to receive air originating from all the avionics bays,
- at least one air duct (138, 138a, 138b) connected to the mixing chamber, and to an air evacuation outlet (130, 130a, 130b) to the outside,
- at least two fans (128a, 128b, 228), arranged and distributed in the air duct(s).

2. Helicopter ventilation architecture according to claim 1, **characterised in that** it comprises two air ducts (138a, 138b), each air duct comprising at least one fan (128a, 128b).

3. Helicopter ventilation architecture according to claim 1, **characterised in that** it comprises one single air duct (138), said single air duct comprising said at least two fans (228).

4. Helicopter ventilation architecture according to one of claims 1 to 3, **characterised in that** it comprises, among the fans, at least one fan supplied with alternating voltage and at least one fan supplied with direct voltage.

5. Helicopter ventilation architecture according to one of claims 1 to 4, **characterised in that** it further comprises a smoke evacuation duct (140) of the helicopter, connected to the mixing chamber.

6. Helicopter, comprising at least two avionics bays comprising electronic equipment **characterised in that** it comprises a ventilation architecture of said avionics bays according to one of the preceding claims.
